Europäisches Patentamt

European Patent Office

Office européen des brevets

(11) Publication number: 0 370 558
A2

# EUROPEAN PATENT APPLICATION

(21) Application number: 89202873.9

(51) Int. Cl.5: G11C 29/00

(22) Date of filing: 13.11.89

(30) Priority: 24.11.88 IT 2271788

(43) Date of publication of application:
30.05.90 Bulletin 90/22

(84) Designated Contracting States:
DE FR GB NL SE

(71) Applicant: SGS-THOMSON
MICROELECTRONICS s.r.l.
Via C. Olivetti, 2
I-20041 Agrate Brianza Milano(IT)

(72) Inventor: Olivo, Marco
Via A. Maj, 22
I-24100 Bergamo(IT)
Inventor: Pascucci, Luigi
Via Ferrara, 9
I-20099 Sesto San Giovanni (Milano)(IT)
Inventor: Villa, Corrado
Via S. Francesco, 31
I-20050 Sovico (Milano)(IT)

(74) Representative: Mittler, Enrico et al
c/o Marchi & Mittler s.r.l. Viale Lombardia, 20
I-20131 Milano(IT)

(54) Writing process with a checkerboard pattern for a matrix of EEPROM memory cells and device for executing the above process.

(57) A first writing impulse executes the writing of all the cells of a first order of lines (odd or even) and a second writing impulse executes the writing of all the cells of a second order of lines (even or odd). Said writing impulses are generated by respective line impulse generators (12, 13) operating alternatively with one another.

Fig.1

**Writing process with a checkerboard pattern for a matrix of EEPROM memory cells and device for executing the above process**

The present invention relates to a writing process with a checkerboard pattern for a matrix of EEPROM memory cells and a device for executing the above process.

The checkerboard pattern, constituted by a uniform spatial alternation of "0" and "1" written in the bits of a memory matrix, is frequently used during a writing session so as to detect certain types of defects.

As in the case of other types of patterns, it requires as many writing or programming impulses as there are matrix bytes (groups of cells written with a single impulse).

It is known that a feature of EEPROM memory cells is to have every byte stored in adjacent cells and to require a very small current, of the order of pF's, for the programming of each single cell.

It is thus possible to write the same word (that is, the group of data contained in any one byte) in all the cells with a single writing impulse.

In the case of a checkerboard pattern it is not, however, possible to accomplish the required alternation between one line of the matrix and the next with said single impulse.

The object of the present invention is to accomplish a writing process for a matrix of EEPROM memory cells which allows the execution of the writing of a checkerboard pattern with a minimum number of writing impulses.

According to the invention such object is attained with a writing process characterized in that it includes the use of a first writing impulse to execute the writing of all the cells of a first order of lines (odd or even) and of a second writing impulse to execute the writing of all the cells of a second order of lines (even or odd) of the matrix.

In this manner just two writing impulses are sufficient to execute the writing of a matrix of EEPROM memory cells in a checkerboard pattern.

The features of the present invention will be more easily understood with reference to the enclosed drawings, wherein:

Fig. 1 shows a matrix of EEPROM memory cells divided into bytes arranged in lines and columns, with which a device is associated for the execution of the writing process with a checkerboard pattern according to the present invention;

Fig. 2 shows one possible embodiment of a generator of a line writing signal included in the device of Fig. 1.

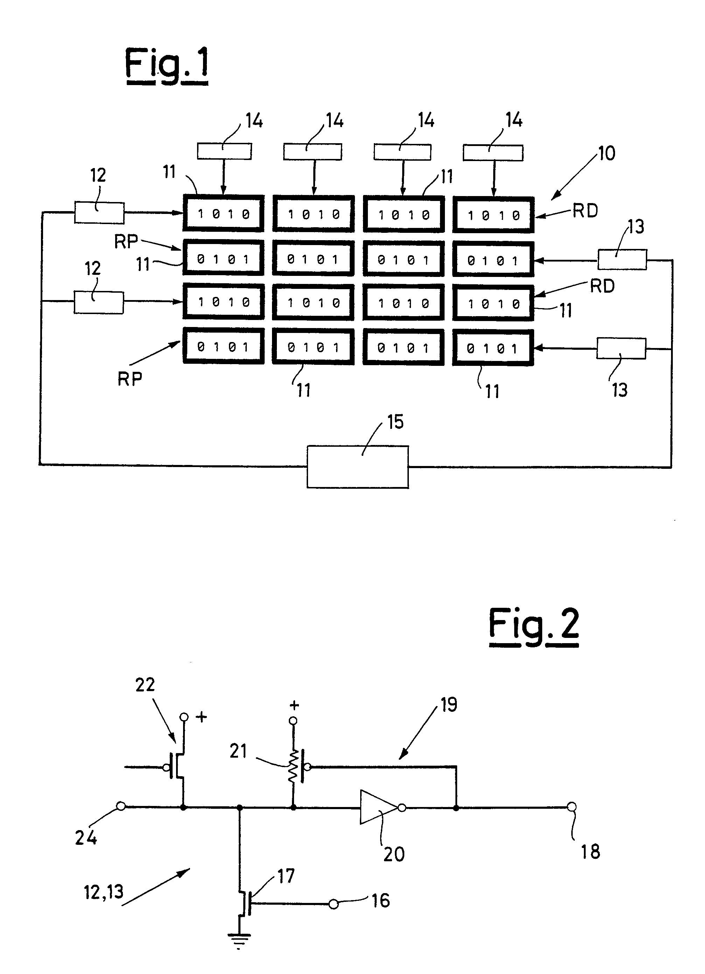

In Fig. 1 there is represented an EEPROM matrix of memory cells 10 divided into bytes 11 each with 4 bits, organized in odd and even lines RD and RP and in columns C.

For the writing of a checkerboard pattern the matrix 10 is provided with a writing device consisting essentially of a first plurality of impulse generators or line decoders 12 for the odd lines RD, by a second plurality for the even lines RP, by a third plurality of impulse generators or line decoders 14 for the columns C and by a clock 15 for the alternating activation of the line generators 12 and 13.

During the writing stage of the above pattern, the generators 12 are at first activated together with the column C generators for the simultaneous writing of all the bytes of the odd lines RD of the EEPROM matrix and the generators 13 are then activated together with the column C generators for the simultaneous writing, with alternate bit patterns, of all the bytes of the even lines RP of the same matrix. With just two impulses the writing of the entire memory is thus obtained.

A possible line generator 12 or 13 is illustrated as an example in Fig. 2 and includes an activation terminal 16 connected to the gate of an N-channel MOS transistor 17, with the source connected to ground and the drain connected to an output terminal 18 by means of a clamping circuit 19 consisting of an amplifier-inverter 20 and a resistive P-channel MOS transistor 21. To these is added a P-channel MOS transistor 22, whose source is connected to a positive power supply and whose drain is connected to an input terminal 24 and whose task it is to pre-load to the same value as the power supply the input terminal 24 through an appropriate command supplied at the gate of transistor 22.

When a positive signal is applied by the clock 15 to terminal 16, transistor 17 starts to conduct and brings to a low level the input of the clamping circuit 19. The output of the latter thus goes to a high level, so as to order the writing of the bytes of the selected line.

**Claims**

1. Writing process with a checkerboard pattern for a matrix of EEPROM memory cells, characterized in that it includes the use of a first writing impulse to execute the writing of all the cells of a first order of lines (RD or RP) of the matrix (10) and of a second writing impulse to execute the writing of all the cells of a second order of lines (RP or RD) of the matrix.

2. Process according to claim 1, characterized in that it includes the use of impulses for writing columns which are simultaneous with said impulses for writing lines.

3. Device for executing the process according to Claim 1, characterized in that it includes at least one first line impulse generator (12), at least one second impulse generator (13), at least one third column impulse generator (14) and a clock (15) for the alternating activation of said line impulse generators (12, 13).

# Fig.1

# Fig.2